Europäisches Patentamt

European Patent Office

Office européen des brevets

(11) Numéro de publication : **0 495 322 B1**

(12) **FASCICULE DE BREVET EUROPEEN**

(45) Date de publication du fascicule du brevet :
**15.11.95 Bulletin 95/46**

(51) Int. Cl.⁶ : **H02G 3/00**

(21) Numéro de dépôt : **91400121.9**

(22) Date de dépôt : **18.01.91**

(54) **Système de contrôle et de commande électrique d'une unité fonctionnelle, notamment d'un logement, bâtiment, atelier, navire ou analogue.**

(43) Date de publication de la demande :
**22.07.92 Bulletin 92/30**

(45) Mention de la délivrance du brevet :
**15.11.95 Bulletin 95/46**

(84) Etats contractants désignés :
**AT BE CH DE DK ES FR GB GR IT LI LU NL SE**

(56) Documents cités :
**EP-A- 0 191 692**
**EP-A- 0 270 438**
**EP-A- 0 319 235**
**FR-A- 2 170 253**
**FR-A- 2 411 438**

(73) Titulaire : **Arnaud, Alain**
**4, rue de la Serpentine**
**F-85270 Saint Hilaire de Riez (FR)**

(72) Inventeur : **Arnaud, Alain**
**4, rue de la Serpentine**
**F-85270 Saint Hilaire de Riez (FR)**

(74) Mandataire : **Wagret, Frédéric Cabinet Wagret**
**23, rue de Saint-Pétersbourg**
**F-75008 Paris (FR)**

## Description

L'invention est relative à un système de contrôle et de commande de l'équipement électrique d'une unité fonctionnelle, notamment une habitation mais aussi adaptée à d'autres réalisations: navigation, constructions industrielles ou collectivités, etc.

L'invention sera ci-après décrite plus particulièrement dans son application pour l'habitation, parce que dans ce cas, son application semble devoir présenter plus d'intérêt comme exposé plus loin.

On sait qu'il est d'usage dans les techniques classiques de construction d'habitation d'utiliser différents équipements d'électricité générale et de préparation relative à cette installation (système électrique précâblé en atelier, pieuvres) qui entraînent beaucoup de manipulations, plus de volume à transporter, les faisceaux risquant de subir des contraintes dans le transport et lors de la pose au niveau des boîtes de jonction: étirement des fils, etc., ces câblages traditionnels donnent des installations relativement limitées, peu aptes pour une extension ultérieure du réseau électrique de l'habitation. Ces câblages sont souvent incompatibles avec les nouvelles technologies telles que la domotique comprenant elle-même des moyens de télécommande haute fréquence, infrarouge ou par courant porteur. On a proposé des installations de distribution électrique pour commander des puissances basse tension B.T. (220 V) par l'intermédiaire de lignes de commande très basse tension T.B.T. (moins de 24 V), un exemple en est donné dans le brevet FR n° 2.170.253 dont le principe met en oeuvre un convertisseur réagissant à des tensions inférieures à 4 V et des puissances inférieures à 1 W. Ce convertisseur donne des signaux à des émetteurs amplificateurs.

Ce type d'installation a pour inconvénient principal son manque de fiabilité en raison des composants et du degré d' isolement insuffisant pour des installations électriques à haut risque (présence d'humidité) où le découplage de sécurité n'est pas atteint.

Un autre exemple est donné par le brevet EP n° 0.191.692 qui décrit un dispositif conforme au préambule de la revendication 1. Un tel dispositif, connu, n'assure pas un découplage suffisant entre les réseaux B.T. et T.B.T. et se présente sous une forme qui n'est pas toujours pratique pour l'installateur parce-que, le plus souvent, les installations sont mises en place par des électriciens qui ne maîtrisent pas les technologies électroniques entrant dans les composants de telles installations.

On connaît encore un autre type d'installation de distribution de courant électrique décrit dans le brevet FR n° 2.607.331.

Dans ce brevet, on a proposé la combinaison d'un premier tableau B.T. (220 V) de type usuel, associé à un second tableau à deux compartiments, l'un servant d'alimentation T.B.T., l'autre au traitement des instructions de commande T.B.T.. On comprend que cette installation nécessite de nombreuses jonctions filaires entre les compartiments desdits tableaux, ce qui présente une difficulté certaine pour l'installateur avec des risques d'erreurs de câblage et aussi des difficultés d'intervention de recherche des anomalies de fonctionnement en cas de panne.

On connaît également par le brevet français publié 2 411 438 un panneau de raccordement électrique auquel aboutit une pluralité de circuits d'arrivée et de départ reliés entre eux par des cartes d'interface, permettant l'émission d'ordre en fonction des signaux reçus; ce dispositif constitue un ensemble limité à la commande d'automatismes programmables à usage industriel et ne règle pas les problèmes de l'alimentation des circuits de signalisation et de commande T.B.T.

L'invention permet à l'installateur de mettre en place un équipement d'ensemble d'une unité fonctionnelle, notamment d'une habitation, permettant d'assurer la totalité des services et fonctions nécessaires, ceci à partir de moyens extrêmement simples, utilisant un réseau filaire constitué de deux types de fil seulement, aboutissant à un coffret de commande unitaire, lequel pourra être équipé, par simple mise en place d'une carte embrochable, de la totalité des fonctions desservies.

Selon un autre objet de l'invention, il reste possible après mise en place du système de contrôle et de commande selon l'invention, d'ajouter au fur et à mesure des besoins ou des agrandissements d'autres équipements, installations ou appareils, susceptibles d'être raccordés dans les mêmes conditions sur le coffret de commande initial, sans modification du réseau.

Selon encore un autre objet de l'invention, on permet une réparation pratiquement immédiate en cas de défaillance de l'ensemble électronique assurant la séquence des fonctions correspondant à un appareil déterminé.

L'invention permet encore, selon un autre objet, une adaptation dans le temps des différentes fonctions, soit que plusieurs modalités ayant été prévues l'opérateur puisse passer d'un régime à l'autre, soit qu'il décide, par simple changement d'un ensemble électronique, de remplacer à titre définitif un régime par un autre, ce qui peut être fait très simplement et sans aucune modification du système, ni remplacement d'appareil.

A cet effet, l'invention concerne un système de contrôle et de commande d'une unité fonctionnelle, notamment d'un logement, bâtiment, atelier, navire ou analogue, conforme à la revendication 1.

Plus spécialement, le système de contrôle et de commande selon l'invention est caractérisé en ce que certains au moins des circuits de commande comportent d'une part des premiers commutateurs de commande locale à actionnement volontaire, notamment manuel, et tels que des boutons poussoirs, ces boutons étant disposés à proximité de l'appareil commandé, et le système comporte d'autre part des seconds commutateurs disposés au niveau du poste central et asservis à des moyens de télécommande.

On peut ainsi selon ce premier développement commander un appareil déterminé soit à proximité de ce dernier, soit par des moyens de télécommande rapprochés ou éloignés, notamment reliés à des moyens de télécommunication, ce qui permet pour un même appareil une mise en actionnement de proximité et une mise en actionnement à partir de signaux émis à distance, soit par une liaison filaire, du type téléphone ou minitel, ou par une liaison hertzienne, notamment rapprochée, du type hyperfréquence ou infrarouge, et à cet effet lesdits seconds commutateurs sont associés à des récepteurs du type radio ou téléphone.

Mais selon un nouveau développement de l'invention, certains au moins des circuits de commande comportent des troisièmes commutateurs soumis à des moyens de programmation; ces derniers peuvent être de type mécanique, électromécanique, ou électronique, ces commutateurs étant interposés sur certains au moins desdits circuits de commande en permettant l'asservissement automatique, à partir desdits moyens de programmation, des appareils contrôlés par ces mêmes circuits.

On a prévu également d'associer au système de commande des moyens de détection tels que des capteurs de positionnement, sondes de température, capteurs d'humidité, cellules photoélectriques, ou encore détecteurs de présence, ces moyens de détection étant interposés sur certains au moins des circuits de commande et aptes, en fonction de l'environnement surveillé par lesdits moyens de détection, à ouvrir ou fermer ledit circuit de commande correspondant à au moins un appareil ainsi asservi à ces moyens de détection.

Selon une forme de réalisation particulièrement avantageuse, lesdits circuits de commande très basse tension reliant les contacteurs décentralisés au poste central sont composés de faisceaux de fils en nombre pair, égal ou supérieur à 4, chaque circuit de commande installé et utilisant deux fils, laissant ainsi en place au moins une paire de fils d'attente permettant l'utilisation du faisceau pour une mise en place ultérieure d'un nouveau circuit de commande à créer, lequel pourra être ainsi mis en place en récupérant les fils laissés en attente et sans que l'on ait à tirer de nouveaux câblages.

Selon encore un développement de l'invention, le poste central est constitué d'au moins une unité modulaire, chaque unité modulaire étant elle-même constitué d'une plaque porteuse d'un circuit imprimé, la plaque comportant sur un bord des moyens de raccordement, tels qu'un premier bornier, sur les circuits de commande très basse tension et de l'autre, des moyens de raccordement sur les circuits d'alimentation, et tels qu'un second bornier, la plaque comportant en outre des moyens récepteurs desdites cartes de fonction embrochables, insérées chacune dans un circuit de commande, suivant un circuit imprimé de la plaque, et le poste central peut ainsi être développé à l'infini par l'adjonction d'une nouvelle unité modulaire, c'est-à-dire d'une nouvelle plaque au fur et à mesure de la mise en place de nouveaux appareils équipant l'installation ou l'unité fonctionnelle desservie.

Avantageusement, chaque carte embrochable est prévue amovible et interchangeable en permettant ainsi soit son remplacement immédiat en cas de panne, soit une modification instantanée du régime correspondant à une carte de fonction déterminée, chaque carte comportant en outre une diode de contrôle qui permet de déterminer l'état de fonctionnement ou non des composants intégrés sur ladite carte, ainsi que l'état de fonctionnement du circuit de commande correspondant à cette carte.

Selon une forme de réalisation plus développée, le poste central comporte au moins une plaque modulaire porteuse d'une part sur un bord longitudinal d'un premier bornier de raccordement à l'ensemble des circuits de commande très basse tension, et d'autre part, sur le bord longitudinal opposé d'un second bornier de raccordement aux circuits d'alimentation, et ladite plaque comporte en outre des socles porteurs de bornes femelles, chaque socle étant prévu pour la réception d'une carte de fonction embrochable, les broches de cette carte étant aptes à être engagées dans les bornes dudit socle, et la plaque comporte encore un circuit imprimé reliant d'une part ledit premier bornier auxdits socles, et lesdits socles à des relais, notamment électromécaniques, eux-mêmes reliés par ledit circuit imprimé au second bornier de puissance, chaque appareil dépendant ainsi de l'installation étant alimenté ou non suivant la position du relais correspondant, lequel est télécommandé par le circuit de commande correspondant passant par la carte embrochable correspondante.

Selon un développement avantageux de l'invention, le circuit imprimé disposé sur ladite plaque porteuse comporte deux lignes conductrices parcourant ladite plaque et reliées à deux bornes femelles de chacun desdits socles d'une part, et à la sortie très basse tension du transformateur d'autre part, en permettant ainsi une alimentation de chacun des circuits de commande par l'intermédiaire de la carte embrochable. En outre, on a avantageusement prévu que au moins une plaque porteuse appartenant audit poste central comporte des moyens, tels qu'une carte électronique d'alimentation, apte à filtrer et réguler ledit courant très basse tension provenant du transformateur et alimentant les circuits très basse tension de commande et de détection, cette carte d'alimentation étant elle-même embrochée sur un socle récepteur et étant interposée entre ledit transformateur délivrant un courant très basse tension et la ligne d'alimentation très basse tension parcourant le circuit imprimé de la plaque porteuse pour desservir l'ensemble des socles eux-mêmes récepteurs des cartes de fonction.

Avantageusement on peut prévoir que certains au moins des circuits de commande comportent une dérivation aboutissant à des moyens de visualisation de l'état marche ou arrêt dudit circuit d'alimentation de l'appareil correspondant.

Plus spécialement, on peut prévoir que chaque circuit de commande dans sa partie extérieure au poste central comporte au moins trois fils, dont deux fils desservant un commutateur très basse tension et un fil de renvoi de l'information sur l'état marche ou arrêt dudit circuit de commande et apte à aboutir à un moyen de visualisation décentralisé, tel qu'une diode électroluminescente disposée notamment à proximité dudit commutateur, et à cet effet, le premier bornier raccordé aux circuits de commande et de contrôle, comporte pour chaque circuit au moins trois bornes raccordées par ledit circuit imprimé de la plaque porteuse à au moins trois bornes du socle récepteur de la carte de fonction embrochable, correspondant audit circuit de commande.

Plus spécialement, dans le cadre d'une variante du système de contrôle et de commande, au moins un circuit de commande est prévu pour aboutir à une liaison téléphonique à un commutateur, notamment constitué d'un appareil de type minitel, lequel est apte à visualiser en utilisant la ligne de renvoi de l'information couplée à la liaison téléphonique, l'état marche/arrêt de certains au moins des circuits de commande en réponse aux instructions transmises.

Selon une caractéristique plus particulière, ledit premier bornier recevant les liaison filaires de contrôle et de commande comporte six bornes pour chaque carte embrochable correspondant à un circuit de commande déterminé, chacune de ces six bornes étant reliée par une ligne du circuit imprimé de la plaque porteuse à une borne du socle récepteur de ladite carte de fonction, ledit socle comportant à cet effet dix bornes réceptrices de dix broches de ladite carte de fonction et correspondant respectivement aux six bornes reliées aux bornes du premier bornier pour raccordement de la liaison filaire permettant l'introduction dans la carte d'une pluralité d'informations aptes à être exploitées par ladite carte, deux autres bornes dudit socle étant reliées aux lignes d'alimentation très basse tension parcourant le circuit imprimé de la carte et enfin les deux bornes restantes dudit socle étant reliées par des lignes dudit circuit imprimé au relais électromagnétique inséré sur le circuit d'alimentation de l'appareil.

Selon encore un développement, certains des circuits de commande très basse tension comportent des liaisons avec des moyens de traitement de l'information permettant l'enregistrement des données correspondant aux mises en fonctionnement ou non dans le temps des appareils desservis par ledit circuit de contrôle et de commande très basse tension.

Le poste central peut en outre comporter un organe récepteur d'informations transmises par voie filaire, notamment téléphonique, ou par voie hertzienne, les informations, sous forme d'impulsions codées étant retransmises à des moyens de décodage reliés par des circuits appropriés à certains au moins des circuits d'alimentation et aptes, en fonction des ordres transmis depuis l'extérieur et reçus par ledit organe de réception, à mettre en position active ou inactive les circuits de commande destinataires des ordres transmis et assurant par les relais correspondants la mise en position active ou inactive de l'appareil à télécommander.

Si l'un des appareils de détection associés au système et à l'installation, est consommateur d'énergie électrique très basse tension, par exemple un détecteur de mouvement fonctionnant par écho radar, dans ce cas son alimentation pourra être assurée par une des paires de fils de la liaison filaire à plusieurs paires de fils reliant ledit appareil au poste central.

On a également prévu de disposer facultativement dans l'ensemble de l'installation une console de contrôle et de commande décentralisée par rapport au poste central, ladite console comportant une pluralité de commutateurs, chaque commutateur étant associé à un voyant de contrôle tel qu'une diode électroluminescente, et le commutateur et ladite diode sont reliés par une liaison filaire d'au moins trois fils au premier bornier de ladite carte porteuse appartenant au poste central, chacun des appareils dépendant de l'installation étant ainsi rendu apte à être surveillé et télécommandé depuis ladite console.

On peut également prévoir qu'un même appareil dépendant d'un circuit de contrôle et de commande, puisse être télécommandé depuis plusieurs commutateurs, chacun des commutateurs raccordés à la même carte de fonction, correspondant audit appareil, étant monté en dérivation sur le circuit de contrôle et de commande, ce qui permet d'actionner le relais assurant la mise en fonctionnement ou la mise hors service de l'appareil depuis une pluralité de commutateurs.

D'autres caractéristiques et avantages de l'invention ressortiront de la description qui suit et qui est donnée en rapport avec une forme de réalisation plus particulière présentée à titre d'exemple et en se référant aux dessins annexés:

- la figure 1 représente un schéma de principe de l'installation à partir d'un appareil auquel correspond un circuit de contrôle et de commande et un circuit d'alimentation, tous deux branchés sur le secteur;
- la figure 2 représente une vue plus élaborée et plus complexe d'un circuit de contrôle et de commande avec interposition d'une carte de fonction;
- la figure 3 représente schématiquement une plaque porteuse appartenant à un poste central et l'ensemble des dispositifs de détection ou de commande interposés sur les divers circuits de contrôle et de commande;
- la figure 4 représente la même plaque appartenant au poste central associé en sortie aux divers appareils fonction ou service électrique télécommandé susceptibles d'être branchés sur l'ensemble de l'installation;
- la figure 5 représente un coffret dans lequel sont positionnées une pluralité de plaques porteuses et de cartes embrochables, l'ensemble constituant un poste central de commande;
- la figure 6 représente une vue en perspective d'une plaque modulaire porteuse d'une pluralité de cartes embrochables;
- la figure 7 représente une vue en plan du circuit imprimé d'une face de la plaque porteuse;
- la figure 8 représente une vue en plan de la plaque porteuse montrant sur un bord le premier bornier de raccordement au circuit de commande et sur le bord opposé, le bornier de raccordement au circuit d'alimentation, entre les deux étant interposés une pluralité de socles correspondant chacun à la réception d'une carte de fonction embrochable;
- la figure 9 représente une vue de détail montrant partiellement l'intérieur d'un coffret constituant le poste de commande avec une vue partielle de deux cartes porteuses jumelées;
- la figure 10a montre une vue en plan du montage pour le raccordement sur la plaque porteuse appartenant au poste central d'une fonction telerupteur.
- la figure 10b montre le schéma électronique de la carte télérupteur de la figure 10a;
- la figure 11a montre le montage d'une fonction minuterie raccordée à une pluralité de boutons-poussoirs avec diodes d'affichage;
- la figure 11b montre le schéma électronique de la carte utilisée dans le montage de la figure 11a;
- la figure 12a montre le montage d'une fonction bouton-poussoir carillon avec gâche électrique, dont la figure 12b montre le schéma électronique de la carte correspondante;
- la figure 13 montre un montage d'une fonction éclairage crépusculaire;
- la figure 14 montre un schéma de montage d'une fonction réglage thermostatique dont la figure 14b donne le schéma électronique de la carte de fonction correspondante;
- la figure 15 montre un schéma de réglage thermostatique avec basculement possible, réglé par une horloge, entre deux régimes soit un régime confort et un régime économique, la figure 15b donnant le circuit électronique de la carte correspondante.

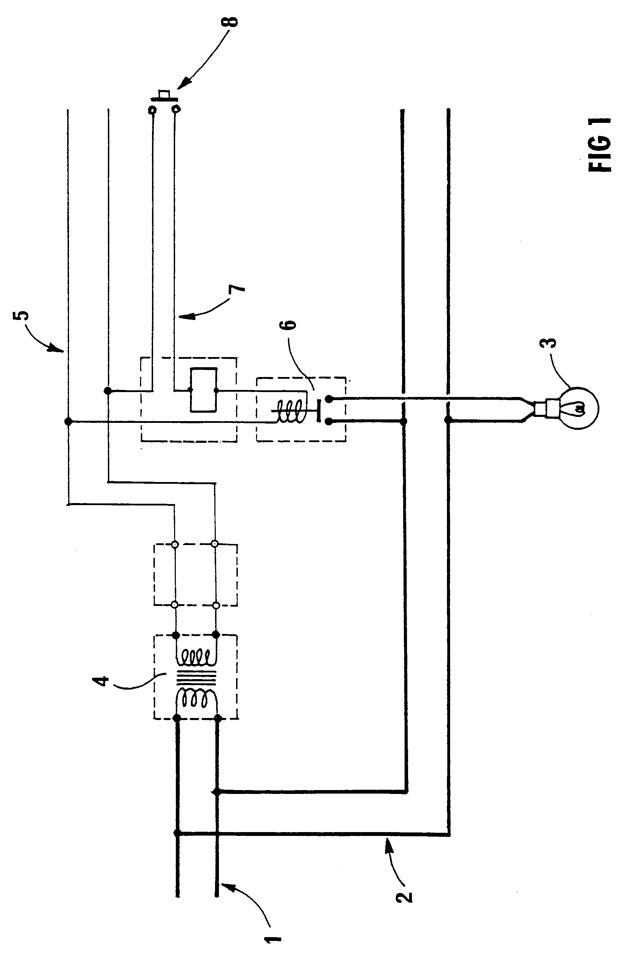

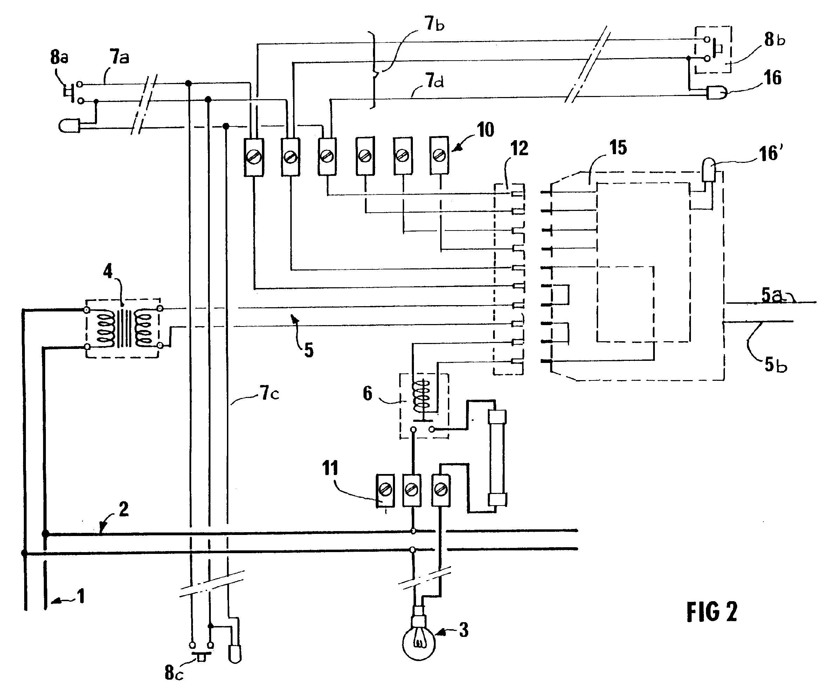

Selon les figures 1 et 2 on voit qu'une source d'alimentation constituée par le secteur 1 dessert un appareil électrique, ici la lampe 3 branchée sur un circuit de dérivation 2.

Le secteur alimente également un transformateur 4 débitant sur le circuit 5 un courant très basse tension par exemple 12 volts.

Sur le circuit de dérivation 2 qui alimente la lampe 3 est monté un relais électromécanique 6 commandé par un circuit de commande et d'alimentation 7, lui-même monté et alimenté en dérivation sur la ligne 5 alimentée en courant très basse tension depuis le transformateur 2.

Sur le circuit de commande 7 est interposé le commutateur, par exemple sous forme du bouton-poussoir 8.

Il est clair que la poussée exercée sur le bouton-poussoir 8 ferme le circuit de contrôle et de commande 7 alimenté depuis 5 et actionne en conséquence le relais 6, lequel ferme à son tour le circuit d'alimentation et permet la mise en fonctionnement de la lampe 3.

Cette disposition est au demeurant conventionnelle ainsi qu'on l'a exposé dans l'introduction et n'est pas l'objet de l'invention, laquelle se situe à l'intérieur de ce cadre général.

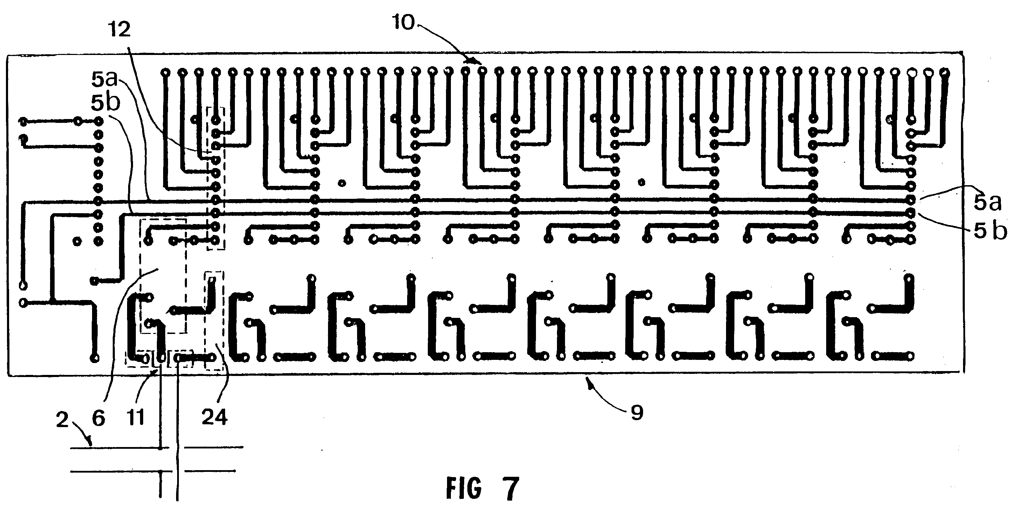

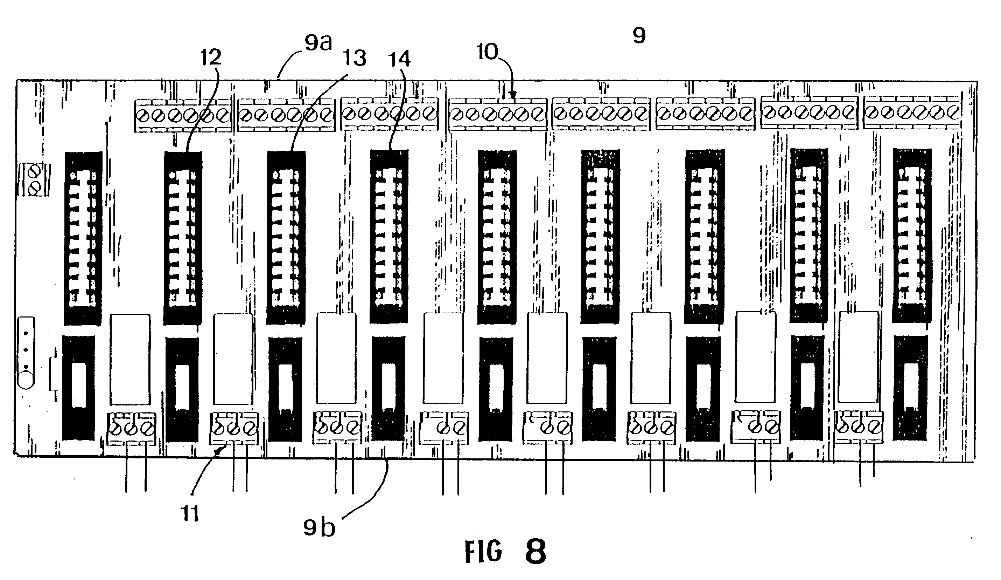

Selon l'invention, on a prévu de disposer au moins une plaque porteuse modulaire représentée en plan sur une face à la figure 8 et par son autre face (circuit imprimé) à la figure 7.

Cette plaque modulaire 9 comporte sur son verso le circuit imprimé représenté à la figure 7 et qui sera décrit ci-après, tandis que sur son recto, elle comporte sur un bord longitudinal 9a un premier bornier 10 destiné à recevoir les circuits de contrôle et de commande (circuits 7 des figures 1 et 2); et sur son bord opposé 9b la plaque porteuse 9 comporte un second bornier destiné à recevoir les circuits d'alimentation (circuits 2 des figures 1 et 2).

Entre le premier bornier (de contrôle et de commande) 10 et le second bornier (d'alimentation) 11 sont alignés des socles 12, 13, 14, etc. destinés à recevoir chacun une carte embrochable de fonction interposée sur le circuit de contrôle et de commande desservant un circuit d'alimentation particulier.

On voit sur le schéma simplifié de la figure 2, l'interconnexion entre le bornier de contrôle et de commande 10 qui reçoit les raccordements sur les divers circuits d'alimentation 7a, 7b, 7c, et le bornier d'alimentation 11.

On voit que, via le circuit imprimé de la figure 7, les six pôles aux bornes du bornier 10 sont raccordés à des bornes femelles du socle 12.

Ce socle 12 comporte dix bornes femelles aptes à recevoir les dix broches de la carte embrochable 15.

Deux de ces broches, et deux des bornes du socle 12 correspondent aux lignes 5a et 5b du circuit imprimé correspondant elles-mêmes à l'alimentation provenant du transformateur 4 et par ces bornes et broches en contact l'alimentation très basse tension peut ainsi desservir via la carte de fonction 15 l'ensemble du circuit de contrôle et de commande passant par chacun des commutateurs 8a, 8b, 8c.

Chacun de ces commutateurs étant monté en dérivation, chacun d'eux peut fermer le circuit qui lui correspond et provoquer par conséquent l'actionnement du relais électromagnétique 6, lequel ferme à son tour le circuit d'alimentation 2 desservant la lampe 3.

De chacun des boutons-poussoirs 8a, 8b, 8c, on peut donc ainsi indifféremment mettre en position active puis inactive, la lampe 3.

A cet effet, les deux dernières broches de la carte de fonction 15 et les deux dernières bornes du socle 12 correspondent au passage du circuit de contrôle et de commande à travers le relais 6 pour en assurer le fonctionnement.

On voit que dans les circuits de contrôle et de commande 7a, 7b, etc., deux fils passent par le commutateur, le troisième fil jumelé provenant de la carte embrochable 15 permet une liaison de renvoi d'information aboutissant à la diode électroluminescente 16 couplée à chacun des commutateurs au bouton-poussoir pour permettre d'afficher au niveau de ce bouton-poussoir l'état marche/arrêt de l'appareil ainsi desservi, ceci notamment dans le cas où le bouton-poussoir est délocalisé par rapport à l'appareil (commande à distance).

L'illustration de la figure 2 qui a été ici décrite correspond à la commande la plus simple (commande d'interrupteur) mise en oeuvre dans le cadre de l'invention; on voit que les composants électroniques (qui seront décrits plus en détail ci-après) ont été simplement schématisés sur la carte 15 de la figure 2.

On précisera que la carte 15 peut elle-même comporter une diode électroluminescente 16′ qui permet ainsi un affichage permanent au niveau de la totalité des cartes présentes sur la plaque 9, l'état de fonctionnement ou non de l'ensemble du circuit de commande et notamment des composants intégrés sur la carte embrochable 15.

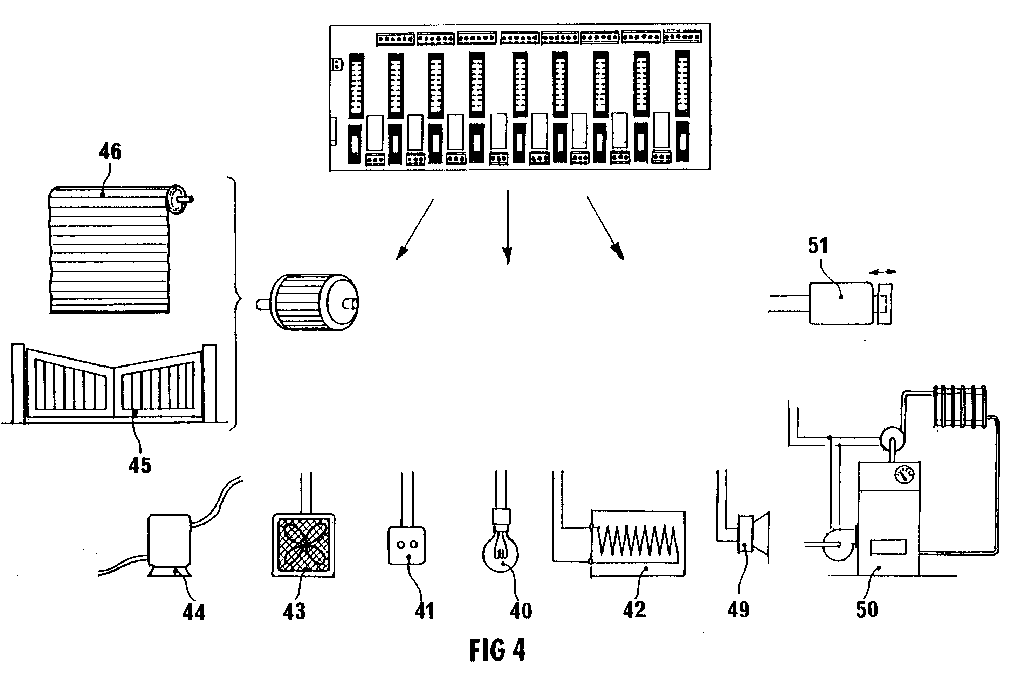

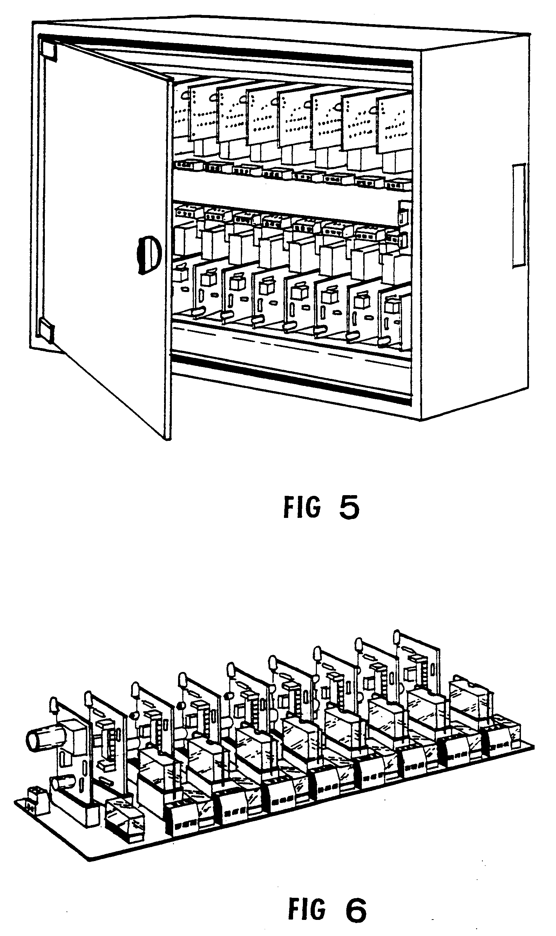

Comme on le voit sur la figure 7 ainsi que sur les figures 4 et 5, la carte porteuse 9 sert de support à une série de socles sur chacun desquels vient s'enficher une carte embrochable correspondant à une fonction ou à un régime de fonctionnement et ceci pour un appareil déterminé.

On comprend que pour chacun des appareils dépendant de l'installation, se trouve mis en place un circuit d'alimentation 2 aboutissant au bornier de puissance ou d'alimentation 11 de la carte 9, correspond également un circuit de contrôle et de commande aboutissant au bornier 10; et pour ce même appareil, auquel est affecté un bornier de puissance et un bornier de commande, est également affecté un socle 12 lui-même récepteur d'une carte embrochable 15 particulière comportant l'ensemble des fonctions voulues pour le régime d'actionnement marche/arrêt de l'appareil.

On regroupe ainsi sur la plaque porteuse 9 ou plaque mère, elle-même modulaire, et donc susceptible d'être multipliée à l'infini, tous les appareils et tous les circuits de contrôle et de commande avec interposition entre les appareils et leur circuit de commande d'une carte embrochable définissant et programmant le régime de fonctionnement de cet appareil (actionnement par bouton-poussoir commandé par télérupteur, minuterie, détecteur automatique, télécommande, etc).

Chaque carte embrochable 15 est elle-même constituée d'une plaquette modulaire comportant la série des broches venant s'enficher dans le socle 12 et elle comporte sur une face de façon connue les circuits imprimés reliant, sur l'autre face, les divers composants électroniques constituant et programmant la fonction voulue.

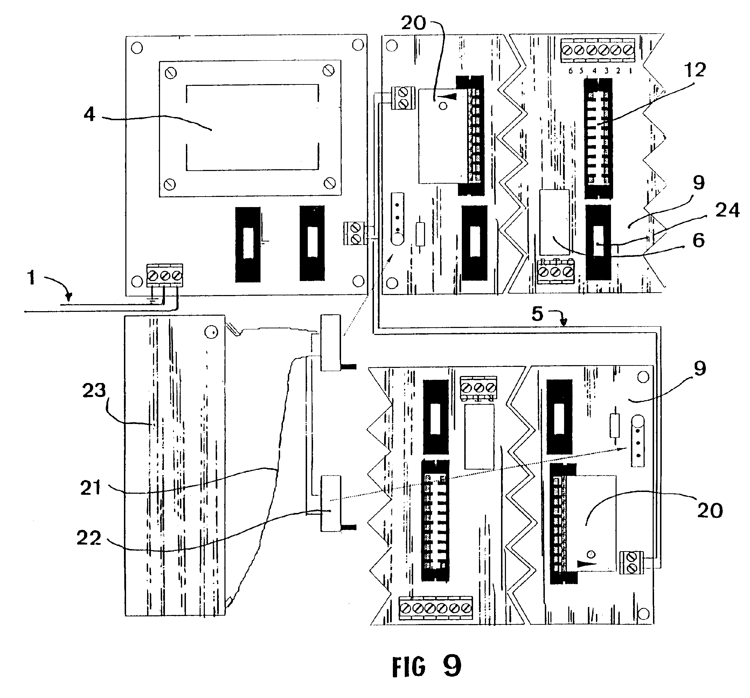

Selon la figure 9, on voit une vue schématique avec arrachage partiel d'un poste central associant deux plaques 9 jumelées.

Ces plaques sont alimentées par le circuit 5 provenant du transformateur 4, lui-même alimenté depuis le secteur 1.

En tête de chaque plaque 9 se trouve situé un premier socle récepteur d'une fiche embrochable pourvue de composants électroniques propres à assurer la filtration et la régulation du courant très basse tension provenant du transformateur et desservant les socles aval et les cartes de fonction que chaque socle comporte.

On voit ainsi sur la figure 9 que chaque carte 9 comporte en tête sa carte de régulation et de filtration de courant très basse tension 20.

On a prévu également associée à chacune des cartes une liaison souple 21 associée à une connectique 22 permettant le branchement des circuits d'alimentation de chaque carte support sur une source d'alimentation autonome par exemple une batterie de sauvegarde 23.

La figure 8 montre le verso de la carte montrant ainsi les circuits imprimés reliant le premier bornier de contrôle et de commande 10 au bornier de puissance et d'alimentation 11 avec passage par les socles 12, 13, 14 récepteurs des cartes embrochables. Un socle de tête 12a étant destiné quant à lui à recevoir la carte embrochable de filtration et de régulation de l'alimentation.

Cette alimentation est assurée au niveau du circuit imprimé par les lignes 5a, 5b qui provenant de la carte de régulation parcourent l'ensemble de la carte longitudinalement pour desservir chacun des socles et assurer ainsi l'alimentation de chacune des cartes de fonction et des circuits de contrôle et de commande qu'elles comportent.

Les deux dernières bornes de chaque socle aboutissant au relais électromagnétique 6 lui-même débouchant sur le bornier de puissance 11 avec interposition en série d'un fusible de protection 24.

L'ensemble du système étant ainsi décrit dans sa structure fonctionnelle, on voit qu'il peut être adapté à tous types de circuits de contrôle et de commande amont comme à tous types d'appareils télécommandés en aval.

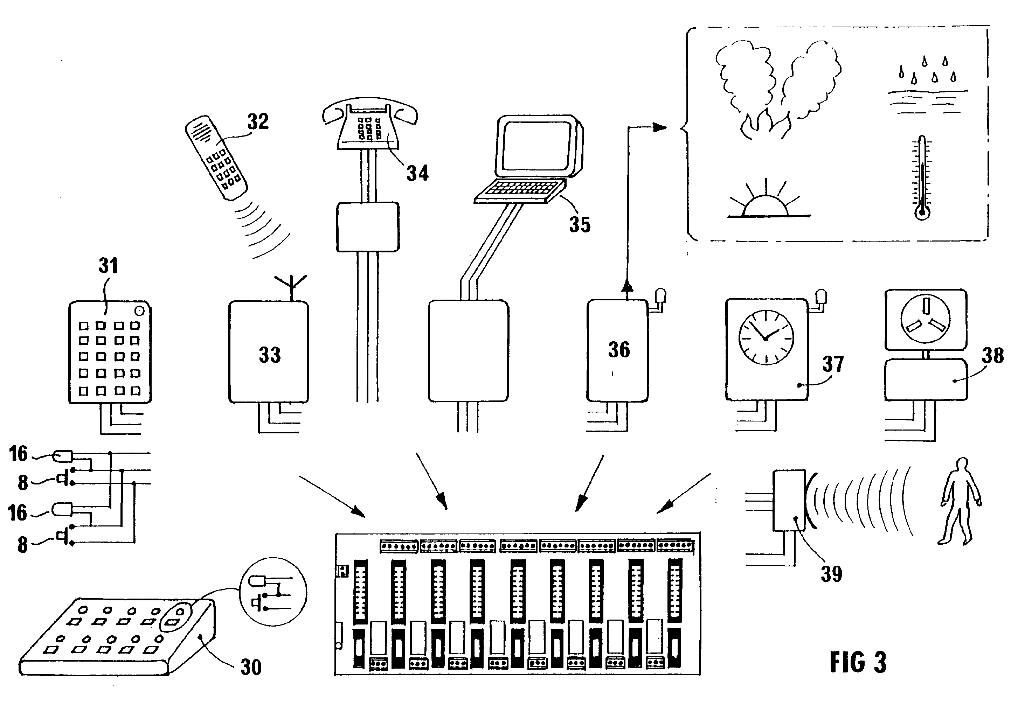

A cet effet, la figure 3 montre un schéma illustrant le raccordement sur le poste de contrôle et de commande comportant une pluralité de cartes porteuses, d'un grand nombre de dispositifs de commutation.

On a ainsi représenté les commutateurs isolés 8 associés chacun à une diode de visualisation 16.

Ces commutateurs sous forme de boutons-poussoirs peuvent être regroupés sur une console de contrôle et de commande 30 reliée par une pluralité de liaisons filaires au premier bornier 10, chaque commutateur correspondant à un appareil déterminé.

Il est ainsi possible de réaliser un poste décentralisé de surveillance par exemple dans une salle de veille, un bureau de direction, etc., permettant de constater à distance l'état de marche/arrêt d'un appareil et généralement de l'ensemble des appareils et installations desservant une unité, le personnel qualifié ayant ainsi la possibilité de décider la mise hors circuit ou la mise en actionnement de chacun des appareils dont l'état est par ailleurs visualisé au niveau de la console.

La commande manuelle du commutateur peut être réalisée par ailleurs sous forme d'un clavier alphanumérique 31 constituant ainsi un "digicode" et permettant par une liaison filaire d'assurer depuis un endroit déterminé la commande ou le contrôle d'un appareil ou de plusieurs appareils.

Ce contrôle peut être réalisé depuis un clavier portatif 32 à par exemple à émission infrarouge ou hyperfréquence et à l'écoute duquel est ouvert en permanence, le poste récepteur radio 33.

La commande peut également être assurée par une liaison filaire à l'extrémité d'un combiné téléphonique 34 ou depuis un clavier minitel 35.

Comme on a vu qu'un fil de renvoi d'information (référence 7′ sur la figure 2) permet de décentraliser l'information sur l'état d'actionnement ou d'arrêt de l'appareil en fonction des ordres antérieurs, il sera ainsi possible par cette liaison 7′ de renvoyer des signaux visualisés sur l'écran minitel permettant ainsi de constater et de repérer sur l'écran d'une façon synthétique l'état de fonctionnement ou d'arrêt des divers appareils interrogés ou commandés.

La télécommande peut également être assurée par des moyens de détection automatiques et sans intervention humaine comme on l'a schématisée sur l'appareil ou sonde 36 qui peut être soit un détecteur de fumée, ou d'élévation de température (détecteur d'incendie), soit une cellule photoélectrique sensible par conséquent à la fin du jour afin d'obtenir un allumage crépusculaire; la sonde peut également être sensibilisée à une température extérieure ou à une présence d'humidité en vue de commander ainsi qu'on le verra en commentant la figure 4, les appareils appropriés.

On comprend que le branchement d'un appareil quelconque via l'interface que constitue la carte de fonction et le circuit de contrôle et de commande sur la sonde 36, permet automatiquement et en dehors de toute présence humaine d'assurer la mise en fonctionnement et l'arrêt de cet appareil à partir de la détection d'un phénomène surveillé et détecté par une sonde appropriée.

La mise en action peut également être programmée à partir d'une horloge 37 en assurant ainsi d'heure à heure le fonctionnement (marche/arrêt) d'un appareil déterminé.

Le renvoi de l'information par la ligne 7′ précédemment commenté peut aboutir à un ensemble de traitement de l'information 38, avec mise en mémoire des séquences dans le temps correspondant aux phases de fonctionnement successif et de marche/arrêt des divers appareils.

Ceci permet non seulement une télésurveillance mais également un enregistrement des données.

La détection de l'appareil 39 correspond à un détecteur de présence fonctionnant par écho radar.

Ce dernier peut être alimenté depuis le circuit très basse tension provenant de la plaque porteuse et alimentée ainsi qu'on l'a vu en très basse tension.

Les signaux correspondant à la détection (ou non détection) des phénomènes sont envoyés sur le bornier 10 et passant par la carte de fonction appropriée sont prévus pour déclencher en fonction de la présence d'une personne ou non la mise en fonctionnement des appareils voulus selon un cycle voulu.

La figure 4 montre le déclenchement en aval, depuis les signaux provenant des circuits de contrôle et de commande amont, des divers appareils raccordés au poste central et appartenant à l'équipement électrique de la maison.

Ces appareils peuvent être constitués de l'ensemble des lampes d'éclairage 40 qui desservent les divers points, pièces et zones de l'habitation tout comme les raccordements d'appareils sur une prise femelle murale 41.

Les appareils ainsi commandés par les différentes sources de commutation précédemment analysées peuvent être, outre l'éclairage, le chauffage 42, selon un cycle de régulation qui sera analysé ultérieurement, la ventilation 43, un vide-cave 44, un portail 45, les volets roulants 48, une sirène d'alarme 49, la chaudière de chauffage central 50, une gâche d'ouverture électrique 51, etc.

Bien entendu, les raccordements se feront de façon spécifique, chaque appareil étant affecté à un type de commande déterminé.

Encore que des basculements d'un régime à l'autre soient possibles, soit volontairement, soit en fonction des plages horaires.

C'est ainsi que le détecteur de présence peut en régime horaire correspondant à la présence normale des habitants, provoquer la régulation du chauffage et l'allumage des pièces où une présence est détectée, tout comme en dehors des plages horaires ou après basculement sur un autre régime, le détecteur de présence servira comme instrument de surveillance et déclenchera en cas de détection d'une présence (alors anormale), la sirène d'alarme 49.

On voit qu'on peut ainsi à partir du poste central réaliser un véritable automate, ceci à partir de moyens extrêmement simples, tant au niveau des raccordements qu'au niveau des composants électroniques.

Puisqu'une simple carte de fonction, elle-même amovible, interchangeable et donc modifiable, suffit pour assurer une programmation ou mise en actionnement en fonction des modalités ou des régimes de fonctionnement voulus.

Ceci sans qu'il soit nécessaire de réaliser des ensembles électroniques ou des moyens informatiques sophistiqués.

L'ensemble des fonctions nécessaires ou utiles pour le cadre de vie peuvent ainsi être mises en place et ensuite jouer leur rôle tout au long de la vie quotidienne sans aucune intervention spécifique et sans aucune maintenance lourde, puisque toute défaillance, constatée par simple visualisation d'une diode d'affichage pourra être remédiée par simple remplacement d'une carte électronique fabriquée en série et donc de faible valeur.

Tandis que au fur et à mesure de l'agrandissement ou de la naissance de nouveaux besoins, une plaque porteuse peut être ajoutée pour servir de support à de nouvelles interconnexions commande/alimentation avec l'interface de fonction appropriée.

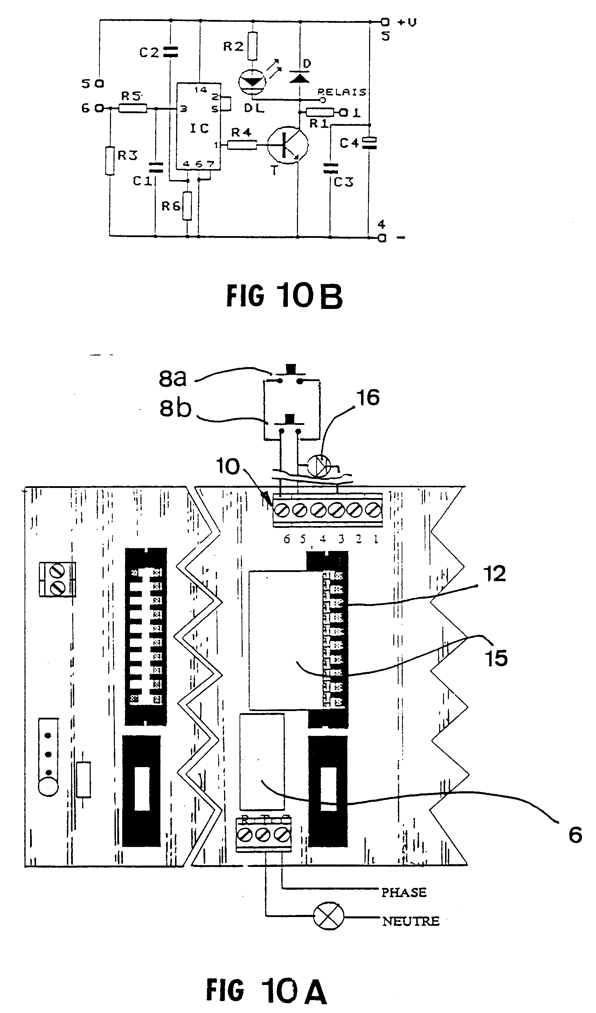

On a décrit aux figures 10 et suivantes quelques exemples de mise en oeuvre de fonctions parmi les plus courantes.

La figure 10a et 10b montrent le raccordement et le montage d'une carte de fonction télérupteur assurant la commande à distance, depuis un emplacement quelconque d'un appareil électrique.

Ainsi qu'on l'a vu à la lumière du schéma de la figure 2, l'appareil peut être commandé (vers marche ou vers arrêt) depuis n'importe lequel des commutateurs ce qui évite les montages en va-et-vient traditionnels lourds consommateurs de fils et d'un fonctionnement de fiabilité parfois douteuse.

On a représenté sur la figure 10 le montage du ou des boutons-poussoirs (en quantité illimitée). Les boutons-poussoirs sont montés en parallèle entre les bornes 5 et 6, la visualisation extérieure de la position marche et arrêt du télérupteur est possible en raccordant une diode au bornier, la patte la plus longue de la diode est reliée à la borne 5, la patte la plus courte à la borne 3.

Le schéma électronique est représenté à la figure 10b et les composants sont précisés dans le tableau ci-après:

| CODE | REF | DÉSIGNATION |
|---|---|---|
| 210000 | S | 0Ω |
| 010116 | R1, R2 | 2.2KΩ |
| 010124 | R3, R4 | 10KΩ |
| 010143 | R5, R6 | 1MΩ |
| 030101 | C1 à C3 | 100 nF |
| 035202 | C4 | 100 à 220uF |
| 040200 | D | 1N4001 à 1N4007 |
| 065100 | DL | LED ROUGE |
| 045100 | T | BC549 ou équ. |
| 050100 | IC | 4013 PHILIPS |

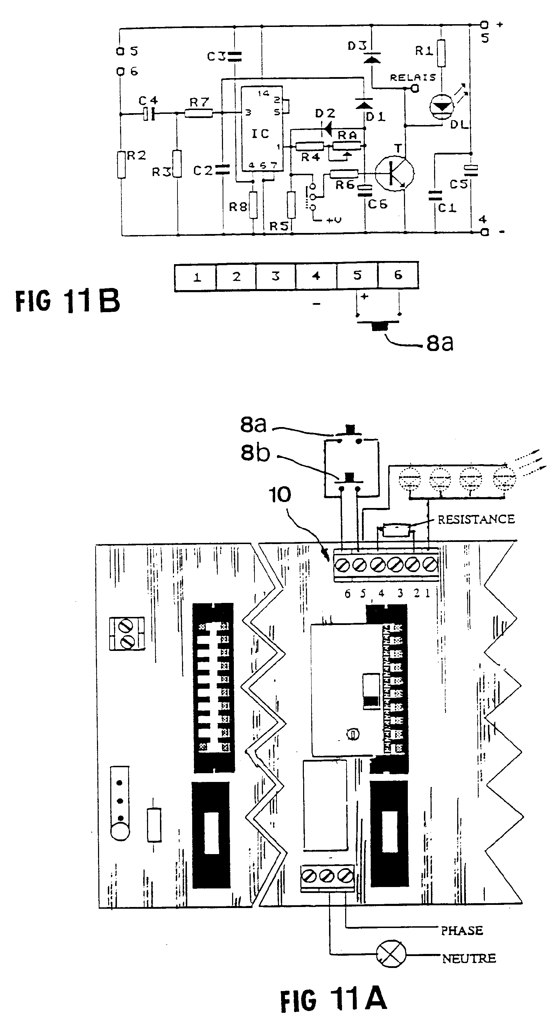

La figure 11a montre un schéma de montage sur la carte porteuse d'une fonction minutée dont la carte de fonction est illustrée dans son schéma électronique et la figure 11b.

Les boutons sont montés en parallèle entre les bornes 5 et 6 du bornier 10.

On a prévu une sortie pour plusieurs voyants constitués de diodes électroluminescentes, lorsque l'on désire visualiser l'emplacement des boutons-poussoirs par exemple dans un couloir sombre.

Le raccordement s'effectue selon le schéma de la figure 11a; la patte la plus longue de la diode est reliée à la borne 5, la patte la plus courte à la borne 2, une résistance est montée entre les bornes 4 et 1, sa valeur étant déterminée comme suit:

- 5 diodes: résistance 470 ohms 5W
- 10 diodes: résistance 220 ohms 5W
- 15 diodes: résistance 100 ohms 5W
- 20 diodes: résistance 47 ohms 5W

Le schéma électronique de la figure 11b correspond aux composants indiqués dans le tableau ci-après:

| CODE | REF | DÉSIGNATION |
|---|---|---|
| 210000 | S | 0Ω |
| 010116 | R1 | 2.2KΩ |
| 010124 | R2 à R6 | 10KΩ |
| 010143 | R7, R8 | 1MΩ |
| 215101 | RA | 1MΩ |
| 030101 | C1 à C3 | 100nF |
| 035103 | C4 | 22uF |
| 035202 | C5 | 100 à 220uF |
| 035107 | C6 | 470uF |
| 040101 | D1, D2 | 1N4148 ou équ. |
| 040200 | D3 | 1N4001 à 1N4007 |
| 065100 | DL | LED ROUGE |
| 045100 | T | BC549 ou équ. |
| 050100 | IC | 4013 PHILIPS |

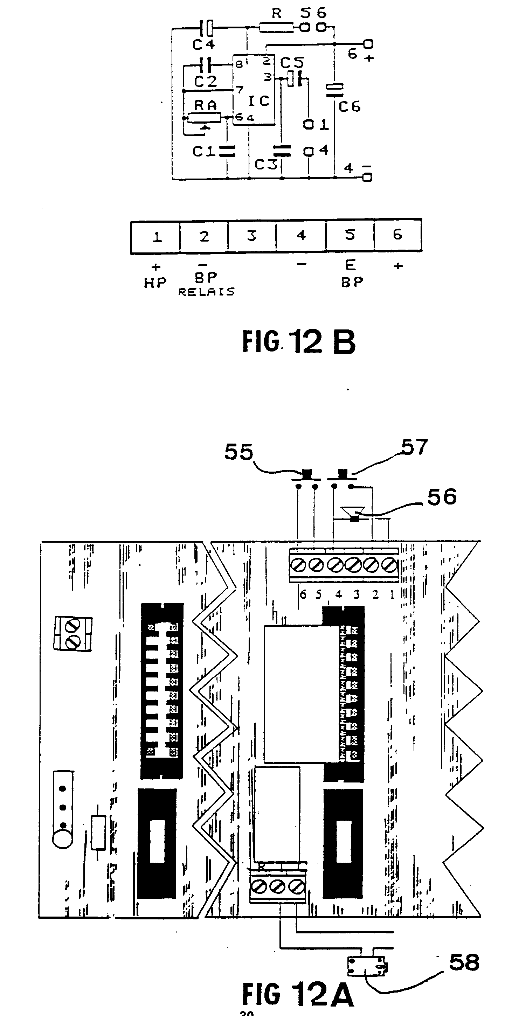

La figure 12a montre le raccordement d'un module carillon et gâche électrique dont la figure 12b donne le schéma électronique avec concordance aux composants indiqués ci-après:

| CODE | REF | DÉSIGNATION |
|---|---|---|
| 210000 | S1 à S3 | 0Ω |
| 010136 | R | 100 KΩ |
| 215502 | RA | 47KΩ |
| 025117 | C1 | 4.7nF |
| 030101 | C2 | 100nF |
| 030102 | C3 | 220nF |
| 035103 | C4 | 22uF |
| 035202 | C5, C6 | 100 à 220uF |
| 050507 | IC | SAB0600 SIEMENS |

Le bouton-poussoir carillon 55 est monté sur les bornes 6 et 5 du bornier de contrôle et de commande. Il actionne ainsi à distance le carillon 56, lui-même monté sur les bornes 4 et 1 du bornier.

En réponse, le bouton-poussoir 57 peut actionner la gâche électrique 58.

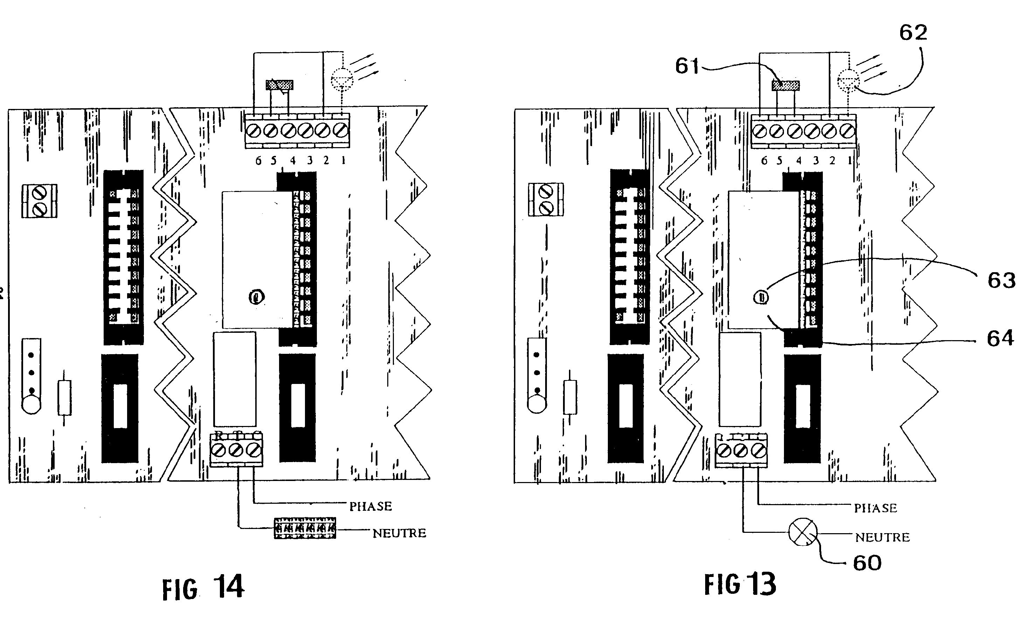

La figure 13 montre le montage d'un interrupteur crépusculaire apte, en fonction de la tombée du jour et de la diminution de la luminosité à commander l'allumage d'un appareil électrique, par exemple une lampe 60, la tombée du jour et la diminution de la luminosité sont détectées par la cellule photoélectrique 61 raccordée aux bornes 4 et 5 du bornier de contrôle et de commande, tandis que les bornes 2 et 6 sont reliées par un pontage, renvoi d'information aboutissant à une diode d'affichage 62 se fait entre les bornes 1 et 2.

Le réglage de la sensibilité se fait par rotation du plot 63 de la carte 64.

Le réglage thermostatique de la figure 14 correspond sensiblement au montage de l'interrupteur crépusculaire de la figure 13.

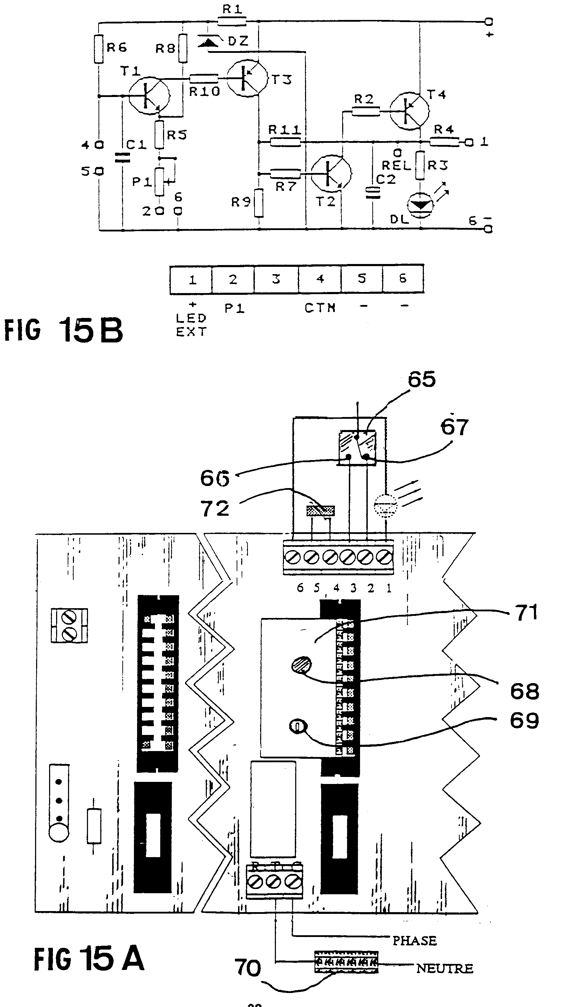

Il sera avantageusement couplé à un ensemble de régulation tel que représenté à la figure 15.

Lequel prévoit la mise en place d'une horloge 65 susceptible de faire basculer le régime de régulation entre les deux plots 66 et 67 correspondant à un régime de fonctionnement économique et à un régime de fonctionnement plus élevé ou de confort.

La sonde de température 72 est montée comme précédemment entre les plots 4 et 5, la température confort peut être réglée à l'aide du bouton manuel 68, tandis que le réglage de la sensibilité de la température économique sera fait par une tournevis sur l'axe de la résistance variable 69, permettant ainsi de régler les battements à l'intérieur d'une gamme de températures extrêmement étroite sur le régime de chauffe de l'appareil de chauffage électrique 70.

Le circuit électronique correspondant à la carte de fonction 71 est donné sur la figure 15b, les composants électroniques étant identifiés et précisés dans le tableau ci-après:

| CODE | REF | DÉSIGNATION |
|---|---|---|
| 010111 | R1 | 560Ω |
| 010116 | R2 à R4 | 2.2KΩ |
| 010121 | R5 | 6.8KΩ |
| 010124 | R6, R7 | 10KΩ |
| 010125 | R8, R9 | 12KΩ |
| 010129 | R10 | 33KΩ |
| 010140 | R11 | 470KΩ |
| 215501 | P1 | 10KΩ |
| 030101 | C1 | 100nF |
| 035104 | C2 | 47uF |
| 040302 | DZ | 9.1V |
| 045100 | T1, T2 | BC549 |
| 245105 | T3, T4 | BC559 |
| 065100 | DL | LED ROUGE |

On comprend que l'invention dans son ensemble permet d'intégrer de nombreux avantages tant au niveau de l'entrepreneur qu'au niveau de l'utilisateur.

L'entrepreneur peut programmer de façon extrêmement simple sur papier les divers équipements et les raccordements sur le coffret central de commande.

Il n'a besoin que de deux types de fils correspondant d'une part au circuit de contrôle et de commande et d'autre part au circuit d'alimentation de puissance.

Il n'est donc pas encombré par le problème de la complexité des fournitures; et il aura constamment en stock les éléments disponibles au moins pour les gros travaux d'implantation et de mise en place des circuits.

L'entretien sera extrêmement simple puisque toute anomalie sera automatiquement détectée dans sa localisation au niveau de la visualisation de la carte mère; le simple remplacement de cette dernière devra permettre de remettre le circuit en service, à défaut de quoi la panne sera automatiquement constatée comme au niveau du circuit d'alimentation, c'est-à-dire au niveau de l'appareil.

Les mêmes avantages se retrouvent au niveau de l'utilisateur qui dispose d'une centrale lui permettant de repérer lui-même directement les anomalies qui "s'auto-affichent".

Le système de l'invention permet de mettre en place de nombreuses fonctions dans un ensemble unitaire, cependant extrêmement simple dans sa mise en place et dans sa surveillance.

Il permet d'incorporer dans une unité d'habitation un grand nombre de fonctions qui jusqu'à présent étaient réalisées par la mise en oeuvre de moyens lourds et onéreux, ceci allant jusqu'à la détection à distance, la programmation, la détection et le déclenchement automatique de nombreuses fonctions et appareils.

L'invention permet donc de réaliser un équipement domotique particulièrement agréable et léger pour l'utilisateur, économique et rationnel avec une multiplication des fonctions et une grande souplesse à toutes les modalités et régimes de fonctionnement; chaque appareil peut être alternativement commuté sur divers types de fonctionnement correspondant chacun à une carte de fonction particulière; ceci en fonction du goût, des humeurs ou des besoins des utilisateurs ou des circonstances de la vie familiale.

L'interconnexion entre plusieurs fonctions permet d'assurer une grande sécurité dans la mise en route des appareils, ces derniers n'étant déclenchés par exemple à distance que si les conditions normales de leur mise en utilisation sont par ailleurs détectées localement et ainsi auto-contrôlées.

Enfin le système permet de renvoyer l'information et non seulement de télécommander, mais également de vérifier que la télécommande a bien été enregistrée et mise à exécution.

La mise en place de réseaux filaires T.B.T. de faible section permet en même temps de multiplier les points de commande, source de confort, et de réduire les poids de cuivre avantage appréciable dans les moyens de transport et source d'économie.

## Revendications

1.  Système de contrôle et de commande d'une unité fonctionnelle, notamment d'un logement, bâtiment, atelier, navire ou analogue, comportant une pluralité d'appareils ou installations électriques devant être commandés, localement ou non, du type dans lequel sont disposés deux types de circuits électriques, à savoir des circuits de commande et de contrôle très basse tension (7) aboutissant à des commutateurs (8) permettant l'ouverture ou la fermeture desdits circuits et des circuits d'alimentation basse tension (2) aboutissant aux appareils (3) commandés, les circuits de commande très basse tension (7) aboutissant à un poste central (9) alimenté depuis le secteur et comportant les circuits d'alimentation correspondants, un transformateur (4) délivrant un courant très basse tension propre à alimenter lesdits circuits de commande très basse tension et, pour chaque appareil desservi, une dérivation interposée sur le circuit d'alimentation (2) dudit appareil, cette dérivation comportant un relais, notamment électro-magnétique (6), commandant l'alimentation dudit appareil, ce relais étant actionné par un circuit de commande (17) correspondant à cet appareil,
    caractérisé en ce que chaque circuit de commande (7), alimenté depuis le transformateur (4), comporte une carte de fonction (15) embrochable et amovible, disposée au niveau du poste central (9) et interposée sur ledit circuit de commande (7), et comportant des moyens électroniques propres à moduler dans le temps et selon un fonctionnement déterminé l'actionnement du relais (6) commandant l'alimentation de l'appareil asservi à ce circuit de commande.

2.  Système de contrôle et de commande selon la revendication 1 ci-dessus, caractérisé en ce que certains au moins des circuits de commande (7) comportent d'une part des premiers commutateurs (8) de commande locale à actionnement volontaire, notamment manuel et tels que des boutons poussoirs et disposés à proximité de l'appareil commandé, et d'autre part des seconds commutateurs disposés au niveau du poste central et asservis à des moyens de télécommande (33, 34, 35).

3. Système de contrôle et de commande selon la revendication 2 ci-dessus, caractérisé en ce que lesdits seconds commutateurs sont asservis à l'action d'impulsions ou signaux émis à distance par liaison filaire, du type téléphone (34) ou minitel (35), ou par liaison hertzienne (33), notamment rapprochée, du type hyperfréquence ou infrarouge et à cet effet lesdits commutateurs sont associés à des récepteurs de type radio ou téléphonique.

4. Système de contrôle et de commande selon les revendications 1 et 2, caractérisé en ce que certains au moins des circuits de commande (7) comportent des troisièmes commutateurs soumis à des moyens de programmation de type mécanique (37), électro-mécanique ou électronique, ces commutateurs étant interposés sur certains au moins des desdits circuits de commande en permettant l'asservissement automatique, à partir desdits moyens de programmation, des appareils contrôlés par lesdits circuits de commande.

5. Système de contrôle et de commande selon l'une des revendications 2, 3 ou 4 ci-dessus, caractérisé en ce qu'il comporte des moyens de détection (36) tels que capteurs de positionnement, sondes de température, capteurs d'humidité, cellules photoélectriques, détecteurs de présence (39) ou analogues, interposés sur certains au moins des circuits de commande et aptes en fonction de l'environnement surveillé par lesdits moyens de détection à ouvrir ou fermer ledit circuit de commande correspondant à au moins un appareil.

6. Système de contrôle et de commande selon l'une des revendications 1 à 5 ci-dessus, caractérisé en ce que les circuits de commande (7) aboutissant aux contacteurs (8) décentralisés par rapport au poste central sont composés de faisceaux de fils en nombre pair égal ou supérieur à 4, chaque circuit de commande installé et utilisant deux fils laissant ainsi en place au moins une paire de fils en attente permettant ainsi l'utilisation du faisceau pour une mise en place ultérieure d'un nouveau circuit de commande à créer.

7. Système de contrôle et de commande selon l'une des revendications 1 à 6 ci-dessus, caractérisé en ce que ledit poste central est constitué d'au moins une unité modulaire, chaque unité modulaire comportant une plaque porteuse (9) d'un circuit imprimé, la plaque comportant en outre d'un côté des moyens de raccordement sur les circuits de commande tels qu'un premier bornier (10) et de l'autre des moyens de raccordement sur les circuits récepteurs (12, 13) tel qu'un second bornier (11) desdites cartes embrochables (15) insérées dans le circuit de commande par lesdits circuits imprimés et ledit poste central pouvant être développé par l'adjonction d'une nouvelle unité modulaire au fur et à mesure de la mise en place de nouveaux appareils desservant l'installation.

8. Système de contrôle et de commande selon l'une des revendications 1 à 7 ci-dessus, caractérisé en ce que les cartes embrochables (15) et insérées sur le poste central (9) dans les circuits de commande (7) sont amovibles et interchangeables en permettant ainsi une modification des fonctions intégrées sur chacun des circuits de commande desservis.

9. Système de contrôle et de commande selon l'une des revendications 1 à 8 ci-dessus, caractérisé en ce que chaque carte embrochable (15) comporte une diode de contrôle (16) permettant de déterminer l'état de fonctionnement ou non des composants intégrés sur ladite carte et le bon fonctionnement du circuit de commande.

10. Système de contrôle et de commande selon l'une des revendications 1 à 9 ci-dessus, caractérisé en ce que le poste central comporte au moins une plaque modulaire porteuse (9), d'une part, sur un côté d'un premier bornier (10) de raccordement à l'ensemble des circuits de commande (7) très basse tension, et d'autre part, sur le côté opposé d'un second bornier (11) de raccordement aux circuits d'alimentation (2), ladite plaque comportant en outre des socles porteurs (12, 13) de bornes femelles, chaque socle étant prévu pour la réception d'une carte de fonction embrochable (15) dont les broches sont aptes à être engagées dans les bornes dudit socle, et la plaque comporte encore sur son verso un circuit imprimé reliant d'une part ledit premier bornier (10) auxdits socles (11, 12, 13) et lesdits socles à des relais (6), notamment électro-mécaniques, eux-mêmes reliés par ledit circuit imprimé au second bornier (11), chaque appareil dépendant de l'installation étant ainsi alimenté ou non, suivant la position du relais correspondant, lequel est télécommandé par le circuit de commande correspondant passant par la carte embrochable correspondante.

11. Système de contrôle et de commande selon la revendication 10, caractérisé en ce que le circuit imprimé comporte deux lignes conductrices (5a, 5b) parcourant ladite plaque et reliées à deux bornes femelles de chacun des socles d'une part, et à la sortie très basse tension du transformateur d'autre part, en vue de l'alimentation de chacun des circuits de commande.

12. Système de contrôle et de commande selon la revendication 11 ci-dessus, caractérisé en ce que au moins une plaque dudit poste central comporte des moyens, tels qu'une carte électronique d'alimentation (20), apte à filtrer et réguler le courant très basse tension provenant du transformateur et alimentant les circuits très basse tension de commande et de détection, cette carte elle-même embrochée sur un socle récepteur étant interposée entre ledit transformateur (4) délivrant un courant très basse tension et la ligne d'alimentation (5a, 5b) très basse tension desservant par des dérivations chaque socle porteur (12, 13) d'une carte de fonction embrochable.

13. Système de contrôle et de commande selon l'une des revendications 1 à 11 ci-dessus, caractérisé en ce que certains au moins des circuits de commande (7) comportent une dérivation (7') aboutissant à des moyens décentralisés de visualisation de l'état de marche ou arrêt dudit circuit d'alimentation.

14. Système de contrôle et de commande selon l'une des revendications 6 à 13 ci-dessus, caractérisé en ce que chaque circuit de commande (7) comporte au moins trois fils, dont deux fils (7) de passage du courant très basse tension aboutissant au commutateur de commande et un fil de renvoi (7') de l'information sur l'état de marche ou arrêt dudit circuit de commande et apte à aboutir à un moyen de visualisation décentralisé tel qu'une diode électro-luminescente (16) disposée notamment à proximité dudit commutateur et, à cet effet, le premier bornier raccordé aux circuits de commande et de contrôle comporte, pour chaque circuit, au moins trois bornes raccordées par ledit circuit imprimé à trois bornes du socle récepteur de la carte de fonction embrochable.

15. Système de contrôle et de commande selon la revendication 14, caractérisé en ce que le circuit de commande aboutit par une liaison téléphonique à un commutateur constitué d'un minitel, lequel est apte à visualiser depuis la ligne de renvoi de l'information, l'état marcha/arrêt de certains au moins des circuits de commande en réponse aux instructions transmises.

16. Système de contrôle et de commande selon la revendication 15, caractérisé par une liaison filaire reliant le poste central à un point de commande décentralisé, tel qu'un commutateur manuel et comportant plus de deux paires de fils aboutissant chacun à une borne du premier bornier, chaque borne du bornier affecté à une carte de fonction embrochable étant reliée par une ligne du circuit imprimé à une borne de socle récepteur de ladite carte.

17. Système de contrôle et de commande selon l'une des revendications 14 à 16, caractérisé en ce que ledit premier bornier (10) comporte six bornes pour chaque carte embrochable (7), chacune de ces six bornes étant reliée par une ligne de circuit imprimé de la plaque à une borne du socle (12) récepteur de ladite carte de fonction, ledit socle comportant dix bornes réceptrices de dix broches de la carte de fonction (15), et correspondant respectivement à six bornes reliées aux bornes du premier bornier pour raccordement de la liaison filaire permettant l'introduction dans la carte d'une pluralité d'informations aptes à être exploitées par la carte, deux autres bornes dudit socle étant reliées aux lignes (5a, 5b) très basse tension pour l'alimentation du circuit de commande correspondant et deux bornes restantes du socle étant reliées par des lignes dudit circuit imprimé au relais électro-magnétique (6) correspondant.

18. Système de contrôle et de commande selon l'une des revendication 1 à 17 ci-dessus, caractérisé en ce que au moins certains des circuits de commande basse tension comportent des liaisons aboutissant à des moyens de traitement de l'information permettant l'enregistrement des données correspondant aux mises en fonctionnement ou non dans le temps des appareils desservis par ledit circuit de contrôle et de commande.

19. Système de contrôle et de commande selon l'une des revendications 1 à 14 ci-dessus, caractérisé en ce que le poste central comporte un organe récepteur d'informations transmises par voie filaire, notamment téléphonique, ou par voie hertzienne, les informations sous forme d'impulsions codées étant retransmises à des moyens de décodage reliés par des circuits appropriés à certains au moins des circuits d'alimentation et aptes, en fonction des ordres transmis depuis l'extérieur et reçus par ledit organe de réception, à mettre en position active ou inactive les circuits de commande destinataires des ordres transmis et commandant par le relais correspondant le circuit d'alimentation de l'appareil à actionner.

20. Système de contrôle et de commande selon l'une des revendications 15 à 19, caractérisé en ce que un commutateur interposé dans le circuit de commande est constitué par un ensemble de détection (39) consommateur d'énergie très basse tension tel qu'un détecteur de mouvement fonctionnant par écho radar et son alimentation est assurée par une des paires de fils de la liaison filaire à plusieurs paires de fils reliant ledit appareil au poste central.

21. Système de contrôle et de commande selon l'une des revendications 1 à 20, caractérisé en ce qu'il comporte une console de contrôle et de commande (30) décentralisée par rapport au poste central, ladite console comportant une pluralité de commutateurs, chacun associé à un voyant de contrôle, chaque ensemble constitué par un commutateur (8) et un voyant tel qu'une diode électro-luminescente (16), étant relié par une liaison filaire d'au moins trois fils au premier bornier (10) dudit poste central et étant monté en dérivation sur un circuit de commande d'un appareil, ainsi apte à être surveillé et commandé depuis ladite console.

22. Système de contrôle et de commande selon l'une des revendication 1 à 21, caractérisé en ce qu'une même carte de fonction est prévue pour être raccordée à une pluralité de circuits de contrôle et de commande, le relais desservi par ladite carte de fonction et l'appareil correspondant étant actionné ou non en fonction des instructions ou informations cumulées provenant desdits circuits.

## Patentansprüche

1. Kontroll- und Steuerungssystem einer Funktionseinheit, insbesondere eines Hauses, eines Gebäudes, einer Werkstatt, eines Schiffes oder dergleichen, mit einer Vielzahl von lokal oder nicht lokal zu steuernder elektrischer Geräte oder Anlagen und mit zwei Arten elektrischer Kreise, nämlich zu Schaltern 8 führenden Kleinspannungs-Steuer- und Regelleitungen (7), die das Öffnen oder Schließen der Kreise ermöglichen, und zu den gesteuerten Geräten (3) führenden Niederspannungsversorgungsleitungen (2), wobei die Kleinspannungskreise (7) zu einem Zentralgerät (9) führen, das vom Versorgungsnetz gespeist wird und entsprechende Versorgungsleitungen, einen Transformator (4), der eine geeignete Kleinspannung zur Versorgung der Kleinspannungs-Steuerkreise liefert, und für jedes angeschlossene Gerät eine von der Versorgungsleitung (2) des betreffenden Geräts abgehende Abzweigung umfaßt, die ihrerseits ein Relais, insbesondere ein elektromagnetisches Relais (6), zur Steuerung der Stromzufuhr zu dem betreffenden Gerät aufweist und über einen diesem Gerät zugeordneten Steuerkreis (17) betätigt wird, dadurch gekennzeichnet, daß für jeden der vom Transformator (4) aus versorgten Steuerkreise (7) eine einsteckbare und entnehmbare Funktionskarte (15) vorgesehen ist, die im Bereich des Zentralgeräts (9) angeordnet ist und in dem Steuerkreis (7) liegt und elektronische Mittel aufweist, mittels derer die Funktion des Relais (6), das die Versorgung des diesem Steuerkreis zugeordneten Geräts steuert, zeitlich und nach einer vorbestimmten Betriebsweise moduliert werden kann.

2. Kontroll- und Steuerungssystem nach Anspruch 1, dadurch gekennzeichnet, daß mindestens einige der Steuerkreise (7) einerseits lokale erste Steuerschalter (8) umfassen, die wahlweise, insbesondere manuell in der Art von Druckknöpfen, betätigt werden können und in der Nähe des gesteuerten Geräts angeordnet sind, und andererseits zweite Schalter aufweisen, die im Bereich des Zentralgeräts angeordnet und mit Fernsteuermitteln (33, 34, 35) verbunden sind.

3. Kontroll- und Steuerungssystem nach Anspruch 2, dadurch gekennzeichnet, daß die zweiten Schalter von Impulsen oder Signalen gesteuert werden, die von fern über eine Drahtverbindung in der Art einer Telefon- (34) oder Minitelefonleitung (35) oder über eine Richtfunkverbindung (33), insbesondere eine Nahverbindung im ultrahohen oder Infrarotbereich, übermittelt werden, und daß für diesen Zweck den Schaltern Funk- oder Telefonempfänger zugeordnet sind.

4. Kontroll- und Steuerungssystem nach den Ansprüchen 1 und 2, dadurch gekennzeichnet, daß mindestens einige der Steuerkreise (7) dritte, mechanischen (37), elektromechanischen oder elektronischen Programmiereinrichtungen unterliegende Schalter umfassen, die mindestens in einigen der Steuerkreise lie-

EP 0 495 322 B1

gen und die automatische Betätigung der über die betreffenden Steuerkreise gesteuerten Geräte von diesen Programmiereinrichtungen aus gestatten.

5. Kontroll- und Steuerungssystem nach einem der Ansprüche 2, 3 oder 4, dadurch gekennzeichnet, daß Detektormittel (36), zum Beispiel Positionssensoren, Temperatursonden, Feuchtigkeitsfühler, Fotozellen, Anwesenheitsfühler (39) oder dergleichen, vorgesehen sind, die zumindest in einigen der Steuerkreise liegen und in Abhängigkeit von der von den Detektormitteln überwachten Umgebung in der Lage sind, den mindestens einem Gerät entsprechenden Steuerkreis zu öffnen oder zu schließen.

6. Kontroll- und Steuerungssystem nach einem der Ansprüche 1 bis 5, dadurch gekennzeichnet, daß die Steuerkreise (7), die zu den relativ zum Zentralgerät dezentral angeordneten Schaltern (8) führen, aus Leiterbündeln mit mindestens vier Leiterpaaren bestehen, so daß jeder installierte Steuerkreis, der zwei Leiter benutzt, mindestens ein Leiterpaar freiläßt derart, daß das Leiterbündel für die spätere Einrichtung eines weiteren Steuerkreises verwendet werden kann.

7. Kontroll- und Steuerungssystem nach einem der Ansprüche 1 bis 6, dadurch gekennzeichnet, daß das Zentralgerät aus mindestens einer modularen Einheit besteht, wobei jede modulare Einheit eine Platte (9) mit einer gedruckten Schaltung umfaßt, die im übrigen einerseits Mittel zum Anschluß an die Steuerkreise, zum Beispiel einen ersten Anschluß 10, und andererseits Mittel, zum Beispiel einen zweiten Anschluß 11, zum Anschluß an die Anschlußleitungen (12, 13) der Steckkarten (15) umfaßt, die mittels der gedruckten Schaltungen in den Steuerkreis geschaltet werden, und wobei das Zentralgerät entsprechend der Installation weiterer zur Anlage gehörender Geräte jeweils um weitere modulare Einheiten erweitert werden kann.

8. Kontroll- und Steuerungssystem nach einem der Ansprüche 1 bis 7, dadurch gekennzeichnet, daß die am Zentralgerät (9) in die Steuerkreise (9) geschalteten Steckkarten herausnehmbar und austauschbar sind und so eine Änderung der Funktionen der einzelnen zugeordneten Steuerkreise ermöglichen.

9. Kontroll- und Steuerungssystem nach einem der Ansprüche 1 bis 8, dadurch gekennzeichnet, daß die Steckkarte (15) eine Kontrolldiode (16) umfaßt, mittels derer festgestellt werden kann, ob die in die Karte integrierten Komponenten in Betrieb sind oder nicht und ob der Steuerkreis ordnungsgemäß arbeitet.

10. Kontroll- und Steuerungssystem nach einem der Ansprüche 1 bis 9, dadurch gekennzeichnet, daß das Zentralgerät mindestens eine modulare Platte (9) aufweist, die einerseits auf ihrer einen Seite einen ersten Anschluß (10) zur Verbindung mit den Kleinspannungs-Steuerkreisen (7) und andererseits auf ihrer gegenüberliegenden Seite einen zweiten Anschluß (11) zur Verbindung mit den Versorgungsleitungen (2) und ferner Sockel (12, 13) mit Anschlußbuchsen aufweist, wobei jeder Sockel für die Aufnahme einer Steck-Funktionskarte (15) vorgesehen ist, deren Stifte in die Buchsen des betreffenden Sockels eingesteckt werden können, und die Platte auf ihrer Rückseite noch eine gedruckte Schaltung trägt, die einerseits den ersten Anschluß (10) mit den Sockeln (11, 12, 13) und die Sokkel mit Relais (6), insbesondere elektromagnetischen Relais, verbindet, die ihrerseits über die gedruckte Schaltung mit dem zweiten Anschluß (11) verbunden sind, so daß die jeweils an die Anlage angeschlossenen Geräte auf diese Weise je nach der Stellung des entsprechenden Relais gespeist oder nicht gespeist werden, wobei die jeweilige Stellung des Relais jeweils über den durch die betreffende Steckkarte hindurchgeführten Steuerkreis ferngesteuert wird.

11. Kontroll- und Steuerungssystem nach Anspruch 10, dadurch gekennzeichnet, daß die gedruckte Schaltung zwei Leiter (5a, 5b) umfaßt, die durch die Platte hindurchgeführt und für die Versorgung der einzelnen Steuerkreise jeweils mit den beiden Anschlußbuchsen jedes der Sockel und andererseits mit dem Kleinspannungsausgang des Transformators verbunden sind.

12. Kontroll- und Steuerungssystem nach Anspruch 11, dadurch gekennzeichnet, daß mindestens eine Platte des Zentralgeräts Mittel, zum Beispiel eine elektronische Anschlußkarte (20), umfaßt, die geeignet sind, den vom Transformator kommenden, die Kleinspannungs-Steuer- und Detektorkreise speisenden Kleinspannungsstrom zu filtern und zu regulieren, wobei diese Karte ihrerseits in einen Anschlußsockel eingesteckt ist, der zwischen dem eine Kleinspannung liefernden Transformator (4) und der Kleinspannungs-Versorgungsleitung (5a, 5b) liegt, die über Abzweige die einzelnen Anschlußsockel (12, 13) einer Steck-Funktionskarte versorgt.

15

13. Kontroll- und Steuerungssystem nach einem der Ansprüche 1 bis 11, dadurch gekennzeichnet, daß mindestens einige der Steuerkreise (7) einen Abzweig (7') aufweisen, der zu dezentral angeordneten Einrichtungen zum Anzeigen des aktiven oder inaktiven Zustandes der Versorgungsleitung führt.

14. Kontroll- und Steuerungssystem nach einem der Ansprüche 6 bis 13, dadurch gekennzeichnet, daß jeder Steuerkreis (7) mindestens drei Leiter umfaßt, darunter zwei eine Kleinspannung führende Leiter (7), die zum Bedienungsschalter führen, und einen Leiter (7') zur Übermittlung von Informationen über den aktiven oder inaktiven Zustand des Steuerkreises, der zu dezentral angeordneten Anzeigemitteln, zum Beispiel einer insbesondere in der Nähe des Schalters angeordneten Leuchtdiode (16) führen kann, und daß hierzu der erste, mit den Steuer- und Überwachungskreisen verbundene Anschluß für jeden Kreis mindestens drei Klemmen aufweist, die über die gedruckte Schaltung mit drei Klemmen des Anschlußsockels der Steck-Funktionskarte verbunden sind.

15. Kontroll- und Steuerungssystem nach Anspruch 15, dadurch gekennzeichnet, daß der Steuerkreis über eine Telefonverbindung zu einem aus einem Minitelefon bestehenden Schalter führt, der in der Lage ist, über die Informationsübermittlungsleitung den aktiven/inaktiven Zustand mindestens einiger der Steuerkreise in Abhängigkeit von den übermittelten Befehlen sichtbar zu machen.

16. Kontroll- und Steuerungssystem nach Anspruch 15, gekennzeichnet durch eine das Zentralgerät mit einem dezentral angeordneten Bedienungspunkt, zum Beispiel einem von Hand zu betätigenden Schalter, verbindende Verbindung, die mehr als zwei jeweils zu einer Klemme eines ersten Anschlusses führende Leiterpaare umfaßt, wobei jede Klemme eines einer Steck-Funktionskarte zugeordneten Anschlusses über eine Leitung der gedruckten Schaltung mit einer Klemme des Anschlußsockels der betreffenden Karte verbunden ist.

17. Kontroll- und Steuerungssystem nach einem der Ansprüche 14 bis 16, dadurch gekennzeichnet, daß der erste Anschluß (10) sechs Klemmen je Steckkarte (7) aufweist, wobei jede dieser sechs Klemmen über eine Leitung der gedruckten Schaltung der Platte mit einer Klemme des Anschlußsockels (12) der Funktionskarte verbunden ist - wobei der Sockel zehn Buchsen für zehn Stifte der Funktionskarte (15) aufweist - und diese Klemmen jeweils sechs Klemmen entsprechen, die zum Anschluß der Leiterverbindung, mittels derer der Karte eine Vielzahl von von der Karte auswertbaren Informationen zugeführt werden kann, mit den Klemmen des ersten Anschlusses verbunden sind, wobei zwei weitere Klemmen des Sockels zur Versorgung des entsprechenden Steuerkreises mit den Kleinspannungsleitungen (5a, 5b) und zwei noch verbleibende Klemmen des Sockels über die Leitungen der gedruckten Schaltung mit dem entsprechenden elektromagnetischen Relais (6) verbunden sind.

18. Kontroll- und Steuerungssystem nach einem der Ansprüche 1 bis 17, dadurch gekennzeichnet, daß zumindest einige der Niederspannungs-Steuerkreise Verbindungen aufweisen, die zu Informationsverarbeitungseinrichtungen führen, mittels derer Daten über die im Laufe der Zeit erfolgte Aktivierung oder Deaktivierung der dem Steuer- und Überwachungskreis zugeordneten Geräte aufgezeichnet werden können.

19. Kontroll- und Steuerungssystem nach einem der Ansprüche 1 bis 14, dadurch gekennzeichnet, daß das Zentralgerät ein Empfangsorgan für Informationen umfaßt, die über Draht, zum Beispiel über eine Telefonleitung, oder per Funk übermittelt werden, wobei die in Form kodierter Impulse vorliegenden Informationen Dekodiermitteln zugeleitet werden, die über entsprechende Leitungen mit mindestens einigen der Versorgungskreise verbunden sind und in Abhängigkeit von den Empfangsorganen von außen zugeführten Befehlen in der Lage sind, jene Steuerkreise zu aktivieren oder zu deaktivieren, für die die übermittelten Befehle bestimmt sind, und die über das entsprechende Relais den Versorgungskreis des betreffenden Geräts steuern.

20. Kontroll- und Steuerungssystem nach einem der Ansprüche 15 bis 19, dadurch gekennzeichnet, daß ein in dem Steuerkreis liegender Schalter aus einer mit einer Kleinspannung arbeitenden Detektoreinheit (39) besteht, zum Beispiel einem mit Echoradar arbeitenden Bewegungsmelder, und daß seine Versorgung über eines der Leiterpaare der das Gerät mit dem Zentralgerät verbindenden, aus einer Vielzahl von Leiterpaaren bestehenden Leiterverbindung erfolgt.

21. Kontroll- und Steuerungssystem nach einem der Ansprüche 1 bis 20, dadurch gekennzeichnet, daß eine relativ zum Zentralgerät dezentral angeordnete Steuertafel vorgesehen ist, die eine Vielzahl von Schaltern umfaßt, denen jeweils eine Kontrollampe zugeordnet ist, wobei jede aus einem Schalter (8) und einer Anzeige, zum Beispiel einer Leuchtdiode (16), bestehende Einheit über eine aus mindestens drei Leitern bestehende Leiterverbindung mit dem ersten Anschluß (10) des Zentralgeräts verbunden ist und von einem Steuerkreis eines Geräts abzweigt, das auf diese Weise von der Steuertafel aus überwacht und gesteuert werden kann.

22. Kontroll- und Steuerungssystem nach einem der Ansprüche 1 bis 21, dadurch gekennzeichnet, daß eine Funktionskarte der beschriebenen Art derart ausgebildet ist, daß sie mit einer Vielzahl von Überwachungs- und Steuerkreisen verbunden werden kann, wobei das der Funktionskarte zugeordnete Relais und das entsprechende Gerät in Abhängigkeit von den gesammelten Befehlen oder Informationen dieser Kreise aktiviert oder nicht aktiviert wird.

## Claims

1. System for monitoring and controlling a functional unit, in particular a house, building, workshop, ship or the like, comprising a plurality of electrical apparatus or installations having to be controlled, locally or not, of the type in which two types of electrical circuits are disposed, namely very low voltage control and monitoring circuits (7) terminating at switches (8) allowing opening or closure of said circuits and low voltage supply circuits (2) terminating at the controlled apparatus (3), the very low voltage control circuits (7) terminating at a central station (9) supplied from the mains and comprising the corresponding supply circuits, a transformer (4) delivering a very low voltage current adapted to supply said very low voltage control circuits and, for each apparatus served, a branch conduit interposed on the supply circuit (2) of said apparatus, this branch conduit comprising a relay, particularly an electro-magnetic one (6), controlling supply of said apparatus, this relay being actuated by a control circuit (17) corresponding to this apparatus,
characterized in that each control circuit (7), supplied from the transformer (4), comprises a plug-in, removable function card (15), disposed at the level of the central station (9) and interposed on said control circuit (7), and comprising electronic means adapted to modulate in time and in accordance with a determined functioning the actuation of the relay (6) controlling the supply of the apparatus servo-controlled by this control circuit.

2. Monitoring and control system according to Claim 1 hereinabove, characterized in that at least certain of the control circuits (7) comprise, on the one hand, first local control switches (8) with voluntary actuation, particularly manual and such as push buttons and disposed near the controlled apparatus and, on the other hand, second switches disposed at the level of the central station and servo-controlled by remote-control means (33, 34, 35).

3. Monitoring and control system according to Claim 2 hereinabove, characterized in that said second switches are servo-controlled by the action of pulses or signals emitted at a distance by wire link, of the telephone (34) or minitel (35) type, or by radio link (33), particularly close, of the ultra-high frequency or infrared type and to that end, said switches are associated with receivers of radio or telephone type.

4. Monitoring and control system according to Claims 1 and 2, characterized in that at least certain of the control circuits (7) comprise third switches subjected to programmation means of mechanical (37), electro-mechanical or electronic type, these switches being interposed on at least certain of said control circuits, allowing the automatic servo-control, from said programmation means, of the apparatus monitored by said control circuits.

5. Monitoring and control system according to one of Claims 2, 3 or 4 hereinabove, characterized in that it comprises detection means (36) such as position sensors, temperature probes, humidity sensors, photoelectric cells, presence detectors (39) or the like, interposed on at least certain of the control circuits and adapted as a function of the environment surveyed by said detection means, to open or close said control circuit corresponding to at least one apparatus.

6. Monitoring and control system according to one of Claims 1 to 5 hereinabove, characterized in that the control circuits (7) terminating at the contactors (8) decentralized with respect to the central station are composed of bundles of wires in an even number equal to or greater than 4, each control circuit installed and using two wires thus leaving in place at least one pair of wires in standby, thus allowing the use of the bundle for subsequent positioning of a new control circuit to be created.

7. Monitoring and control system according to one of Claims 1 to 6 hereinabove, characterized in that said central station is constituted by at least one modular unit, each modular unit comprising a board (9) bearing a printed circuit, the board further comprising on one side means for connection on the control circuits such as a first terminal strip (10) and, on the other, means for connection on the receiver circuits (12, 13) such as a second terminal strip (11), of said plug-in cards (15) inserted in the control circuit by said printed circuits and said central station being able to be developed by the addition of a new modular unit as new apparatus serving the installation are placed in position.

8. Monitoring and control system according to one of Claims 1 to 7 hereinabove, characterized in that the plug-in cards (15) inserted on the central station (9) in the control circuits (7) are removable and interchangeable, thus allowing modification of the functions integrated on each of the control circuits served.

9. Monitoring and control system according to one of Claims 1 to 8 hereinabove, characterized in that each plug-in card (15) comprises a monitoring diode (16) making it possible to determine the state of functioning, or not, of the components integrated on said card and correct functioning of the control circuit.

10. Monitoring and control system according to one of Claims 1 to 9 hereinabove, characterized in that the central station comprises at least one modular board (9) bearing, on the one hand, on one side, a first terminal strip (10) for connection to the assembly of the very low voltage control circuits (7) and, on the other hand, on the opposite side, a second terminal strip (11) for connection to the supply circuits (2), said board further comprising bases (12, 13) bearing female terminals, each base being provided for receiving a plug-in function card (15) whose pins are adapted to be engaged in the terminals of said base, and the board also comprises on its rear a printed circuit connecting, on the one hand, said first terminal strip (10) to said bases (11, 12, 13) and said bases to relays (6), particularly electro-mechanical ones, themselves connected by said printed circuit to the second terminal strip (11), each apparatus depending on the installation thus being supplied or not, depending on the position of the corresponding relay, which is remote-controlled by the corresponding control circuit passing through the corresponding plug-in card.

11. Monitoring and control system according to Claim 10, characterized in that the printed circuit comprises two conducting lines (5a, 5b) passing over said board and connected to two female terminals of each of the bases on the one hand, and to the very low voltage output of the transformer on the other hand, with a view to supplying each of the control circuits.

12. Monitoring and control system according to Claim 11 hereinabove, characterized in that at least one board of said central station comprises means such as an electronic supply card (20) adapted to filter and regulate the very low voltage current coming from the transformer and supplying the very low voltage control and detection circuits, this card itself plugged on a receiver base being interposed between said transformer (4) delivering a very low voltage current and the very low voltage supply line (5a, 5b) serving by branch conduits each base (12, 13) bearing a plug-in function card.

13. Monitoring and control system according to one of Claims 1 to 11 hereinabove, characterized in that at least certain of the control circuits (7) comprise a branch conduit (7') terminating at decentralized means for displaying the state of operation or stop of said supply circuit.

14. Monitoring and control system according to one of Claims 6 to 13 hereinabove, characterized in that each control circuit (7) comprises at least three wires, of which two wires (7) for passage of the very low voltage current terminating at the control switch and one wire (7') for returning the information on the state of operation or stop of said control circuit and adapted to terminate at a decentralized display means such as an electro-luminescent diode (16) disposed in particular near said switch and, to that end, the first terminal strip connected to the control and monitoring circuits comprises for each circuit at least three terminals connected by said printed circuit to three terminals of the base receiving the plug-in function card.

15. Monitoring and control system according to Claim 14, characterized in that the control circuit terminates by a telephone link at a switch constituted by a minitel, which is adapted to display from the information return line the state of operation/stop of at least certain of the control circuits in response to the instructions transmitted.

16. Monitoring and control system according to Claim 15, characterized by a wire link connecting the central station to a decentralized control point such as a manual switch and comprising more than two pairs of wires each terminating at a terminal of the first terminal strip, each terminal of the terminal strip allocated to a plug-in function card being connected by a line of the printed circuit to a terminal of base receiving said card.

17. Monitoring and control system according to one of Claims 14 to 16, characterized in that said first terminal strip (10) comprises six terminals for each plug-in card (7), each of these six terminals being connected by a printed circuit line of the board to a terminal of the base (12) receiving said function card, said base comprising ten terminals receiving ten pins of the function card (15), and corresponding respectively to six terminals connected to the terminals of the first terminal strip for connection of the wire link allowing the introduction in the card of a plurality of data adapted to be exploited by the card, two other terminals of said base being connected to the very low voltage lines (5a, 5b) for supplying the corresponding control circuit and two remaining terminals of the base being connected by lines of said printed circuit to the corresponding electromagnetic relay (6).

18. Monitoring and control system according to one of Claims 1 to 17 hereinabove, characterized in that at least certain of the low voltage control circuits comprise links terminating at data processing means allowing recording of the data corresponding to the settings in operation, or not, in time of the apparatus served by said monitoring and control circuit.

19. Monitoring and control system according to one of Claims 1 to 14 hereinabove, characterized in that the central station comprises a member receiving information transmitted by wire link, particularly telephone, or by radio link, the information in the form of coded pulses being retransmitted to decoding means connected by appropriate circuits to at least certain of the supply circuits and adapted, as a function of the orders transmitted from the outside and received by said receiving member, to place in active or inactive position the control circuits addressees of the orders transmitted and controlling by the corresponding relay the supply circuit of the apparatus to be actuated.

20. Monitoring and control system according to one of Claims 15 to 19, characterized in that a switch interposed in the control circuit is constituted by a detection assembly (39) consuming very low voltage energy such as a movement detector functioning by radar echo and its supply is ensured by one of the pairs of wires of the wire link with a plurality of pairs of wires connecting said apparatus to the central station.

21. Monitoring and control system according to one of Claims 1 to 20, characterized in that it comprises a monitoring and control console (30) decentralized with respect to the central station, said console comprising a plurality of switches, each associated with a monitor, each assembly constituted by a switch (8) and a monitor such as an electro-luminescent diode (16), being connected by a wire link of at least three wires to the first terminal strip (10) of said central station and being mounted in shunt on a control circuit of an apparatus, thus adapted to be supervised and controlled from said console.

22. Monitoring and control system according to one of Claims 1 to 21, characterized in that the same function card is provided to be connected to a plurality of monitoring and control circuits, the relay served by said function card and the corresponding apparatus being actuated or not as a function of the cumulated instructions or information coming from said circuits.

FIG 1

EP 0 495 322 B1

FIG 2

FIG 3

FIG 4

23

FIG 5

FIG 6

FIG 7

FIG 8

EP 0 495 322 B1

FIG 9

**FIG 10 B**

**FIG 10 A**

28

FIG 11 B

FIG 11 A

29

## FIG. 12 B

| 1 | 2 | 3 | 4 | 5 | 6 |
|---|---|---|---|---|---|

+     −         −     E     +

HP    BP            BP
    RELAIS

## FIG 12A

FIG 14

FIG 13

PHASE

NEUTRE

PHASE

NEUTRE

61

62

63

64

60

31

EP 0 495 322 B1

FIG 15 B

FIG 15 A